# EUROPÄISCHE PATENTSCHRIFT

(11) **EP 4 206 843 B1**
(45) Veröffentlichungstag und Bekanntmachung des Hinweises auf die Patenterteilung: **24.04.2024**
(21) Anmeldenummer: 22215439.5
(22) Anmeldetag: 21.12.2022
(51) Int. Cl.: G05B 23/02, G01R 27/02

(54) **VERFAHREN ZUR AUTOMATISCHEN ERSTELLUNG VON ANLAGENSPEZIFISCHEN MESSPROFILEN FÜR EIN ISOLATIONSÜBERWACHUNGSSYSTEM**
METHOD FOR AUTOMATICALLY CREATING INSTALLATION-SPECIFIC MEASUREMENT PROFILES FOR AN INSULATION MONITORING SYSTEM
PROCÉDÉ DE CRÉATION AUTOMATIQUE DE PROFILS DE MESURE SPÉCIFIQUES À UNE INSTALLATION POUR UN SYSTÈME DE SURVEILLANCE D'ISOLATION

(30) Priorität: 28.12.2021 DE 102021006389
(43) Veröffentlichungstag der Anmeldung: 05.07.2023
(73) Patentinhaber: Bender GmbH & Co. KG, 35305 Grünberg (DE)
(72) Erfinder: Hackl, Dieter, 35463 Fernwald (DE)
(74) Vertreter: advotec.

(56) Entgegenhaltungen:
- EP-A1- 3 467 597
- EP-A1- 3 904 896
- DE-A1-102016 224 459

## Beschreibung

Die Erfindung betrifft ein Verfahren zur automatischen Erstellung von anlagenspezifischen Messprofilen für ein Isolationsüberwachungssystem einer elektrischen Anlage.

Aus der EP 3 904 896 sind Isolationsüberwachungsgeräte mit einer Vielzahl spezieller Messprofile bekannt, womit ein reales Systemverhalten der elektrischen Anlage einschließlich des Auftretens symmetrischer Fehler simuliert werden können.

Aus der EP 3 467 597 ist die computergesteuerte Unterstützung von Inbetriebnahme, Wartung, Fehlerbehebung durch automatische Generierung von Handlungsanweisungen an eine Bedienperson im Zusammenhang mit Komponenten der Gebäudeautomatisierung bekannt.

Aus der DE 10 2016 224459 sind visuelle Assistenzsysteme für Inspektionstätigkeiten mit Messungen und Dokumentation der Messergebnisse bekannt.

Nach der Norm DIN VDE 0100-410 bzw. IEC 60364-4-41 ist ein ungeerdetes Stromversorgungssystem - im Folgenden als elektrische Anlage bezeichnet - mit einem Isolationsüberwachungsgerät (installation monitoring device - IMD) auszurüsten, um den Isolationswiderstand der elektrischen Anlage zu überwachen und das Auftreten eines ersten Fehlers zwischen einem aktiven Teil der elektrischen Anlage und einem Körper eines Betriebsmittels (Körperschluss) oder gegen Erde (Erdschluss) zu melden. Die in der Produktnorm IEC 61557-8 spezifizierten und auf dem Markt verfügbaren Isolationsüberwachungsgeräte sind im Hinblick auf eine bestimmte Verwendung oftmals in Gerätevarianten für spezielle Anwendungen verfügbar oder für einen breiteren Einsatzbereich mit in dem Gerät hinterlegten Messprofilen für ca. 80 % der Anwendungen konfigurierbar.

Als Nachteil der nach dem Stand der Technik verfügbaren Isolationsüberwachungssysteme erweist sich, dass für Anwendungen mit abweichenden Anforderungen unter hohem Aufwand kundenspezifische, d.h. anlagenspezifische Messprofile mit geeigneten Messprofil-Parametern erstellt werden müssen.

Beispielsweise muss zunächst ein grundsätzliches Messprinzip ausgewählt werden, wie z.B. ein Unsymmetrieverfahren oder ein Impulsverfahren, und für dessen digitale Implementierung sind Abtastraten und Filtergrenzfrequenzen sowie zulässige Störgrenzwerte als Messprofil-Parameter festzulegen.

Die Einstellung der Messprofil-Parameter erfordert daher zeit- und kostenintensive Serviceeinsätze von Experten vor Ort an der elektrischen Anlage des Kunden. Die manuell von den Experten durchzuführenden Schritte zur Erstellung eines anlagenspezifischen Isolationsüberwachungsgeräte-Messprofils vor Ort beginnen dabei in der Regel mit der Analyse der Kundenanlage, um ein Gesamtverständnis für die Anwendung zu erlangen. Darauf folgen eine detaillierte Analyse der Betriebszustände im Regelbetrieb der elektrischen Anlage und die Diagnose der Auswirkungen von Störgrößen auf die Isolationsüberwachung. Anhand der Erfassung von Messdaten wird das Messverhalten des Isolations- überwachungsgeräts beobachtet, um abschließend geeignete Messprofil-parameter zu ermitteln, die einen zuverlässigen, störungsfreien Isolationsüberwachungsgeräteeinsatz in der vorliegenden Anwendung ermöglichen.

In personal- und damit kostenintensiver Weise erfolgt bislang das Auswählen einer Isolationsüberwachungsgerätevariante, die am besten für die gewünschte Anwendung geeignet erscheint, durch Vertriebsmitarbeiter, Servicemitarbeiter oder Produktmanager, um anschließend durch diesen Personenkreis eine mit erheblichem Zeitaufwand verbundene manuelle Anpassung der Isolationsüberwachungsgeräte-Messprofilparameter vornehmen zu können.

Der vorliegenden Erfindung liegt somit die Aufgabe zugrunde, ein Verfahren zu beschreiben, welches die manuell von Experten durchzuführenden Schritte zur Erstellung eines anlagenspezifischen Isolationsüberwachungsgeräte-Messprofils an der elektrischen Anlage des Kunden vor Ort vereinfacht und gegenüber dem Stand der Technik weniger personal-, zeit- und kostenintensiv gestaltet.

Diese Aufgabe wird durch die erfindungsgemäßen Merkmale des Verfahrens nach Anspruch 1 gelöst.

Der Grundgedanke der vorliegenden Erfindung beruht darauf, die bei dem Kunden vor Ort tätigen Fachkräfte, welche zwar eine Anwendungsexpertise, jedoch keine tiefgreifenden Kenntnisse auf dem Gebiet der Isolationsüberwachungstechnik besitzen, in der Weise zu unterstützen, dass die bereits beim Kunden vorhandene technische Ausstattung, beispielsweise Smartphones und Tablet-PCs einschließlich der darin verbauten Sensorik, als Assistenzsystem bei der Erstellung des anlagenspezifischen Isolationsüberwachungsgeräte-Messprofils technisch nutzbar gemacht wird. Dazu wird die handelnde Person Computerprogramm-gesteuert über das Assistenzsystem mit Handlungsanweisungen zur Ausführung von technischen Maßnahmen angeleitet, um ohne zusätzliche Unterstützung eines Experten für Isolationsüberwachungstechnik anlagenspezifische Isolationsüberwachungs-Messprofile erstellen zu können.

Um eine Analyse der elektrischen Anlage des Kunden durchzuführen, erfolgt in einem ersten Schritt ein Computerprogramm-gesteuertes Assistieren mittels des Assistenzsystems durch geführte Handlungsanweisungen zum Erfassen von technischen und nicht technischen Anlagendaten.

Über das Assistenzsystem wird der bei dem Kunden tätigen Fachkraft eine Abfolge von Handlungsanweisungen präsentiert, die die Person dazu anleitet, technische Daten (physikalische Größen) und nicht technische Daten (typische Anlagenkenngrößen und technische Angaben) der elektrischen Anlage einschließlich des an der Anlage installierten Isolationsüberwachungssystems zu erfassen.

Gemäß den durch das Assistenzsystem Computerprogramm-gesteuert vorgegebenen Handlungsanweisungen erfolgt ein teilautomatisiertes und/oder automatisiertes Ausführen der Handlungsanweisungen zum Erfassen der Anlagendaten mittels einer oder mehrerer Sensoreinrichtung(en).

Diese Datenerfassung außerhalb des Regelbetriebs erfolgt optisch, akustisch oder allgemein mit einer Erfassungssensorik, die in der Lage ist, für die Analyse der elektrischen Anlage relevante Objekte (beispielsweise Typenschilder oder verbaute Betriebsmittel) oder auftretende technische Effekte und physikalische Größen (beispielsweise Anlagengeräusche, Schwingungsverläufe bewegter Maschinenteile oder Strom- /Spannungsverläufe) aufzunehmen. Bei der teilautomatisierten Ausführung der Handlungsanweisungen kann das Anleiten zum Ausführen von manuellen Tätigkeiten dialogorientiert im Sinne einer Benutzerführung erfolgen.

Basierend auf den so erfassten Anlagendaten erfolgt ein Computerprogramm-gestütztes Vor-Auswählen eines vorhandenen Messprofils.

Dazu kann ein in dem Isolationsüberwachungssystem hinterlegtes, bestmögliches Messprofil ausgewählt werden oder die Anlagendaten werden mit Inhalten in einer Anlagendatenbank verglichen, um bereits in vergleichbaren Kundenanlagen erfolgreich zum Einsatz gekommene Messprofile für Isolationsüberwachungssysteme in einer Vorselektion zu ermitteln.

In einem nächsten Schritt erfolgt ein Computerprogramm-gesteuertes Assistieren mittels des Assistenzsystems durch geführte Handlungsanweisungen zum Betreiben der elektrischen Anlage in einem Regelbetrieb mit wechselnden Betriebszuständen unter Anwendung des vor-ausgewählten Messprofils mit Erfassen von Anlagen-Messdaten und mit synchronem Aufzeichnen des Messverhaltens des Isolationsüberwachungssystems mittels Speicherung von Isolationsüberwachungssystem-Messdaten während des Regelbetriebs.

Im Unterschied zu den in dem ersten Schritt erfassten Anlagendaten, welche Daten betreffen, die außerhalb des Regelbetriebs zur Analyse der elektrischen Anlage erhoben werden, bezeichnen die Messdaten diejenigen Daten, die während des Regelbetriebs erfasst werden, wobei eine Unterscheidung in (allgemeine) Anlagen-Messdaten und (spezielle) Isolationsüberwachungssystem-Messdaten vorgenommen wird.

Die auch in diesem Schritt von dem Assistenzsystem vorgegebenen Handlungsanweisungen veranlassen die Fachkraft einen Regelbetrieb der elektrischen Anlage durchzuführen. Dabei erfolgt ein Durchfahren aller möglichen, insbesondere der kritischen, Betriebszustände mit einer periodisch sich wiederholenden Reihenfolge dieser Betriebszustände wie dies auch im Produktivbetrieb zu erwarten ist.

Neben den in dem ersten Schritt außerhalb des Regelbetriebs durchgeführte Erfassung von technischen und nicht technischen Anlagendaten zur Analyse werden nun während des Regelbetriebs Anlagen-Messdaten anhand entsprechend positionierter Sensorik erfasst - vorzugsweise dort, wo störungsrelevante Anlagen-Messdaten zu erwarten sind.

Damit werden voneinander unterscheidbare Anlagenbetriebszustände mit ihren jeweiligen Anlagen-Messdaten sowie die zeitliche Abfolge der Betriebszustände erfasst. Eine dem jeweiligen Betriebszustand zugeordnete mögliche Störbeeinflussung des Isolationsüberwachungssystems wird durch synchrones Aufzeichnen des Messverhaltens des Isolationsüberwachungssystems mittels Speicherung von Isolationsüberwachungssystem-Messdaten während des Regelbetriebs festgehalten.

Dann erfolgt ein Bewerten des Messverhaltens des Isolationsüberwachungssystems.

Die Bewertung des Messverhaltens, also die Beobachtung und Auswertung der Reaktion des Isolationsüberwachsungssystems auf Basis der in dem Regelbetrieb aufgezeichneten Isolationsüberwachungssystem-Messdaten kann dabei zu dem Ergebnis führen, dass erstens durch die Vorselektion ein Messprofil bestimmt wurde, das zu einem zufriedenstellenden Messverhalten in allen Betriebszuständen führt und somit keine Störbeeinflussung des Isolationsüberwachungssystems stattfindet, oder zweitens, dass durch die Vorselektion ein Messprofil gefunden wurde, das nicht in allen Betriebszuständen störungsfrei arbeitet, oder drittens, dass durch die Vorselektion ein Messprofil bestimmt wurde, das in keinem der Betriebszustände zu einem zufriedenstellenden Ergebnis führt.

In dem ersten Fall arbeitet die Isolationsüberwachung mit dem vorselektierten Messprofil zufriedenstellend und die Aufgabe kann als gelöst betrachtet werden.

In dem zweiten Fall kann aufgrund der in den meisten Betriebszuständen hinreichend zuverlässig arbeitenden Isolationsüberwachung eine Strategie darin bestehen, bei den kritischen Betriebszuständen die ermittelten Messwerte zu verwerfen, um Fehlalarmmeldungen zu vermeiden.

Falls sich jedoch, wie im dritten Fall, das Messverhalten in allen oder in der überwiegenden Anzahl der Betriebszustände als störanfällig erweist, erfolgt ein Ermitteln von Störgrößen aus den Anlagen-Messdaten.

Dazu werden mithilfe von Methoden der digitalen Signalverarbeitung wie beispielsweise digitalen Filter- oder Transformationsalgorithmen, störungsrelevant Signale der Sensoreinrichtungen in den erfassten Anlagen-Messdaten für jeden Betriebszustand analysiert, um die darin enthaltenen Störanteile (Störgrößen) zu ermitteln.

Eine elektrische Störgröße kann sich beispielsweise durch einen auffälligen Strom- oder Spannungsverlauf (Ausreißer) auszeichnen oder die Störgröße kann mechanischer Natur sein und sich durch auffällige Maschinengeräusche oder Maschinenschwingungen bemerkbar machen. Mit geeigneten Sensoreinrichtungen werden die Störsignale erfasst und mit Hilfe der digitalen Signalverarbeitung erkannt.

Anschließend erfolgt ein Simulieren des Regelbetriebs mit dem vor-ausgewählten Messprofil unter Anwendung der mit den Störgrößen behafteten Anlagen-Messdaten.

Es wird eine simulierte Isolationsüberwachung auf der Basis des an der elektrischen Anlage installierten Isolationsüberwachungssystems mit dem vor-ausgewählten Messprofil und mit den Störgrößen-behafteten Anlagen-Messdaten durchgeführt.

Abschließend erfolgt ein Optimieren des vor-ausgewählten Messprofils durch Anpassen von Messprofil-Parametern im Hinblick auf eine störresistente Isolationsüberwachung.

Mit digitalen Signalverarbeitungsalgorithmen oder mittels adaptiver Verfahren werden die Parameter des vor-ausgewählten Messprofils so optimiert, dass das Isolationsüberwachungssystem in allen Betriebszuständen störungsfrei arbeitet.

Der Optimierungsprozess läuft dabei dezentral in der Sensoreinrichtung (Edge-Computing) ab oder die Anlagen- und Isolationsüberwachungssystem-Messdaten werden zur zentralen Auswertung über eine Netzinfrastruktur, beispielsweise ein Funknetz, an einen zentralen Server weitergeleitet (Cloud-Computing), wobei die Übergänge zwischen "Edge" und "Cloud" fließend sein können.

In weiterer vorteilhafter Ausgestaltung ist das Assistenzsystem ein Endgerät des Anlagenbetreibers in Form eines Smartphones, eines Tablet-PCs, eines Notebooks, einer Virtual Reality Brille (VR-Brille) oder Augmented Reality Brille (AR-Brille) und das Computerprogramm-gesteuerte Assistieren erfolgt mittels eines auf dem Endgerät ausführbaren Anwendungsprogramms.

Im Sinne der aufgabengemäßen personal-, kosten und zeiteffizienten Erstellung des anlagenspezifischen Messprofils wird auf die bei dem Anlagenbetreiber vorhandene Technik und Sensorik zurückgegriffen. Vorzugsweise eignen sich dazu mobile Endgeräte, wobei auf dem Markt ("App Store") verfügbare Assistenzanwendungen als Anwendungsprogramme ("Apps") auf dem Endgerät des Anlagenbetreibers installiert werden.

Die weitgehende Verfügbarkeit und die zunehmende Verbreitung mobiler Endgeräte führen in Verbindung mit der zunehmenden Digitalisierung industrieller Prozesse zu einer gesteigerten Effizienz des erfindungsgemäßen Verfahrens.

Mit Vorteil wird das Computerprogramm-gesteuerte Assistieren durch Virtual Reality Verfahren (VR-Verfahren) und/oder Augmented Reality Verfahren (AR-Verfahren) unterstützt.

Mit den VR- oder AR-Verfahren lassen sich die Handlungsanweisungen sowie erfasste Anlagendaten, Anlagen-Messdaten und Isolationsüberwachungssystem-Messdaten direkt an einer gewünschten Stelle der elektrischen Anlage visualisieren bzw. projizieren, sodass die angewiesenen Tätigkeiten auch ohne Expertenwissen und ohne weitere Hilfsmittel von Fachkräften durchgeführt werden können.

Bevorzugt erfolgt das Erfassen der Anlagendaten sowie der Anlagen-Messdaten mittels in dem Assistenzsystem verbauter Sensoreinrichtungen.

Da bekannte als Assistenzsystem verwendete, insbesondere mobile, Endgeräte (Smartphones) zu einem überwiegenden Teil bereits mit optischen, akustischen oder Bewegungs- und haptischen Sensoren ausgestattet sind, kann diese Sensorik effizient zur Erfassung der Anlagendaten und der Anlagen-Messdaten genutzt werden.

Alternativ und ergänzend zu der bereits an dem Assistenzsystem (Endgerät) vorhandenen Sensorik können - wie aus dem Stand der Technik bekannt - separate, an einer elektrischen Maschine angebrachte und vorzugsweise über eine Funkübertragung angebundene Sensoren die Anlagen-Messdaten erfassen.

Bevorzugt werden bei dem Optimieren des vor-ausgewählten Messprofils durch Anpassen von Messprofil-Parametern Verfahren der Künstlichen Intelligenz (KI) angewendet.

Verfahren der Künstlichen Intelligenz ermöglichen durch Erkennen von Korrelationen in Daten aus der Vergangenheit, wie beispielsweise in vorhandenen Daten aus der Isolationsüberwachung ähnlicher elektrischen Anlagen, Entscheidungsregeln für die Optimierung der Messprofil-Parameter in der aktuellen Überwachungssituation aufzustellen.

Vorzugsweise erfolgt eine Übertragung der Anlagen-Messdaten und der Isolationsüberwachungssystem-Messdaten mittels einer Funkübertragungsstrecke.

Über eine in dem Assistenzsystem, beispielsweise in dem Smartphone als Endgerät, vorhandene Funkschnittstelle werden Anlagen-Messdaten und Isolationsüberwachungssystem-Messdaten an eine zentrale Recheneinheit (Server) übermittelt, um mit Hilfe von Isolationswiderstands-Simulationen und KI-Anwendungen ein für die Anlagenbetriebszustände optimiertes Messprofil für das Isolationsüberwachungssystem zu erstellen und mittels der bidirektionalen Funkübertragungsstrecke zu testen.

Die Funkübertragungsstrecke kann ein drahtloses lokales Funknetz (WLAN) oder ein Mobilfunknetz (5G-Standard) sein.

Die Analyse-, Simulations- und Optimierungsprozesse werden nicht zwingend auf dem Assistenzsystem (Smartphones des Anlagenbetreibers) ausgeführt, sondern können mittels der Funkübertragungsstrecke an eine geeignete Rechnerinfrastruktur (Server) im Hintergrund übermittelt werden und dort ablaufen.

Die Überwachungsaufgabe des Isolationsüberwachungssystems ist dann erfüllt, wenn störungsfrei arbeitende Messprofil-Lösungen für eine hinreichende Anzahl von Betriebszuständen in dem Regelbetrieb der elektrischen Anlage gefunden werden.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern. Es zeigen:
- **Fig. 1**: Eine Computerprogramm-gesteuerte Erfassung von Anlagen daten - Bildaufnahme eines Typenschilds eines Industrieroboters,
- **Fig. 2**: eine Computerprogramm-gesteuerte Erfassung von Anlagendaten - Bildaufnahme eines Typenschilds eines Schaltschranks,
- **Fig.3**: eine Computerprogramm-gesteuerte Erfassung von Anlagendaten - Bildaufnahme von Einstellungen des Isolationsüberwachungssystems,
- **Fig. 4**: eine Computerprogramm-gesteuerte Erfassung von Anlagendaten - Bildaufnahme von Anlagendaten,
- **Fig. 5**: eine Computerprogramm-gesteuerte Erfassung von AnlagenMessdaten und Isolationsüberwachungssystem-Messdaten-Bildaufnahme von Betriebszuständen und Messverhalten,
- **Fig. 6**: eine Computerprogramm-gesteuerte Erfassung von Anlagenund Isolationsüberwachungssystem-Messdaten mit Funkübertragung,
- **Fig. 7**: ein Ermitteln von Störgrößen mittels Sensoreinrichtungen und digitaler Signalverarbeitung und
- **Fig. 8**: ein Ermitteln von Störgrößen mittels eines zweiten mobilen Endgeräts und digitaler Signalverarbeitung.

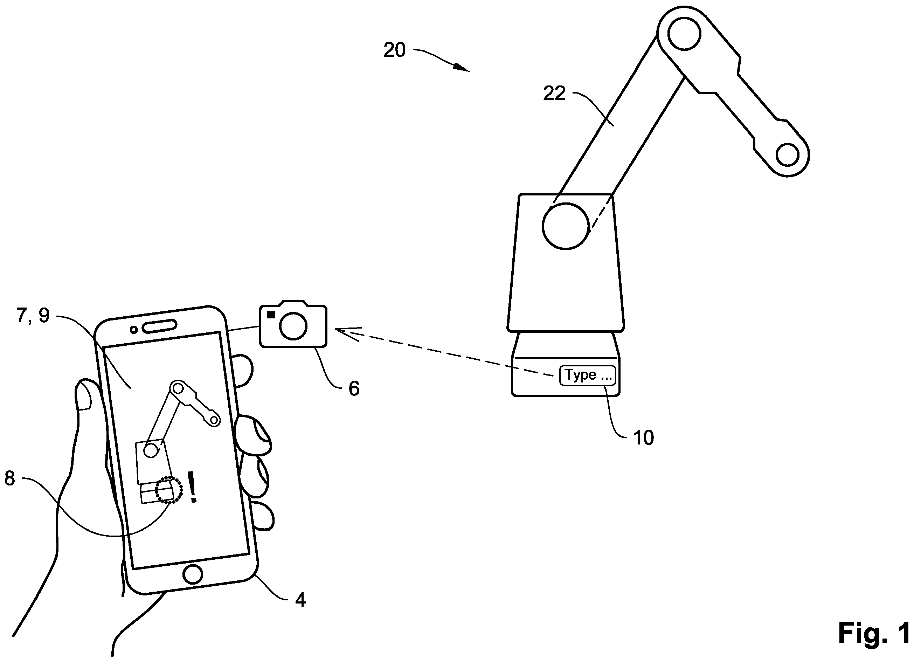

**Fig. 1** zeigt eine elektrischen Anlage 20 mit einer als Industrieroboter 22 ausgebildeten elektrischen Maschine 22.

An dem Industrieroboter 22 ist ein Typenschild angebracht, auf welchem relevante Kenngrößen des Industrieroboters 22 als Anlagendaten 10 vermerkt sind. Mit einer Kamera als Sensoreinrichtung 6 eines als Smartphone ausgeführten Assistenzsystems 4 werden diese Anlagendaten 10 erfasst. Dazu ist auf dem Smartphone 4 ein Anwendungsprogramm 7 installiert, welches durch Computerprogramm-gesteuerte und Benutzergeführte verbale oder bildliche Handlungsanweisungen 9 auf dem Bildschirm des Smartphones 4 den Benutzer zum Erfassen der Anlagendaten 10 anleitet. Die Handlungsanweisungen 9 werden durch ein AR-Verfahren 8 unterstützt.

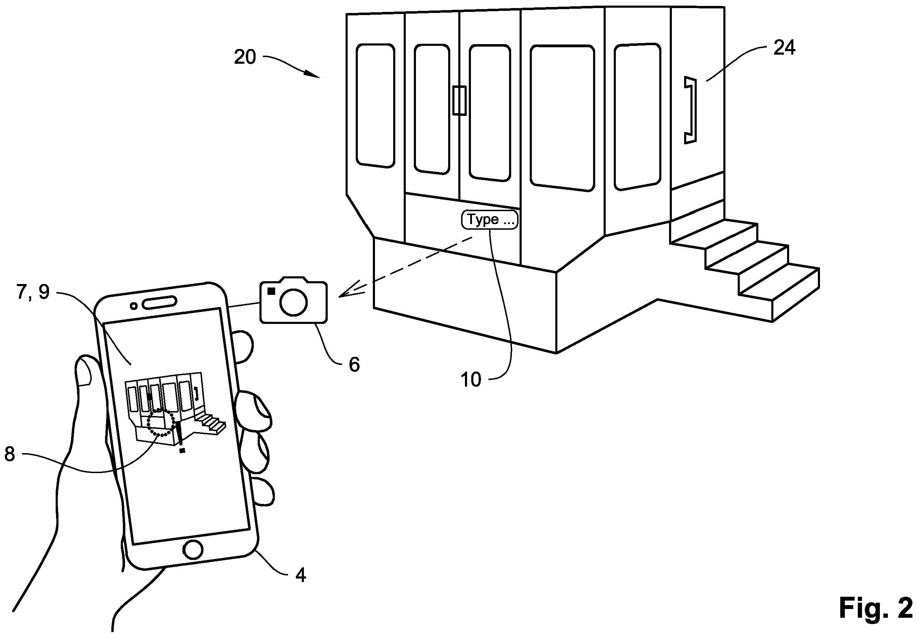

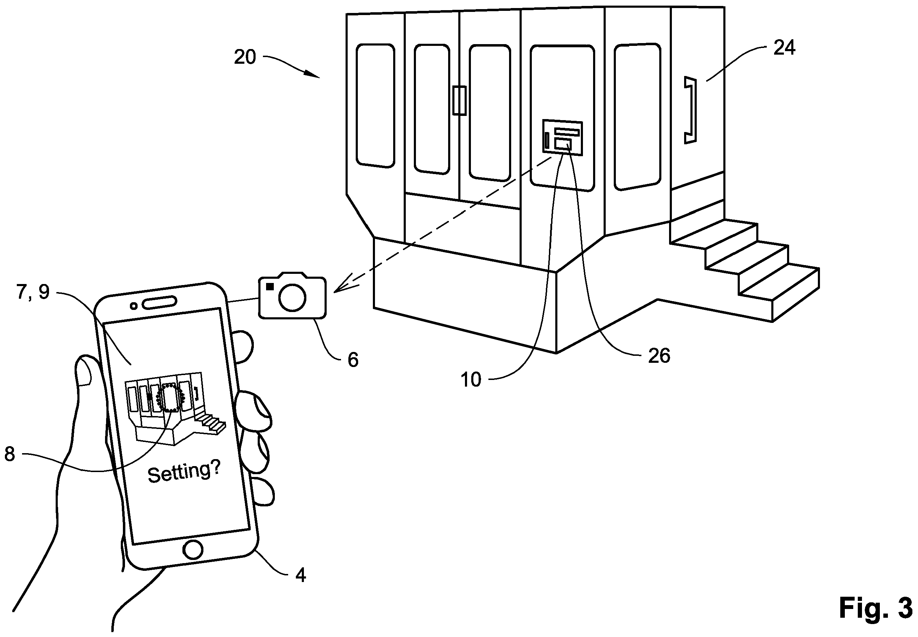

**Fig. 2** zeigt als weiteren Bestandteil der elektrischen Anlage 20 einen Schaltschrank 24, in dem ein oder mehrere Typenschild(er) mit Anlagendaten 10 der in dem Schaltschrank 24 verbauten Geräte, wie beispielsweise ein Isolationsüberwachungssystem 26 (Fig. 3), angebracht sind.

Diese Anlagendaten 10 werden gemäß den Handlungsanweisungen 9 des implementierten Anwendungsprogramms 7 und mit Unterstützung eines AR-Verfahrens 8 mit der Kamera 6 des Assistenzsystems 4 (Smartphone) erfasst.

Aus den auf den Typenschildern enthaltenen Anlagendaten 10, insbesondere der Typenbezeichnung, oder aus der Bildaufnahme eines geöffneten Schaltschrankes 24 können wichtige Anlageneigenschaften abgeleitet werden.

Insbesondere werden, wie in **Fig. 3** dargestellt, als Anlagendaten 10, Einstellungen des in dem Schaltschrank 24 verbauten Isolationsüberwachungssystems 26 mit der Kamera 6 aufgenommen.

Im Zuge der Analyse der elektrischen Anlage 20 erfolgt im Hinblick auf die Erstellung, insbesondere bei der Vor-Auswahl eines Messprofils, eine Erfassung der (Parameter-)Einstellungen des Isolationsüberwachungssystems 26, angeleitet von dem Anwendungsprogramm 7 mit den Handlungsanweisungen 9 und unterstützt durch das AR-Verfahren 8.

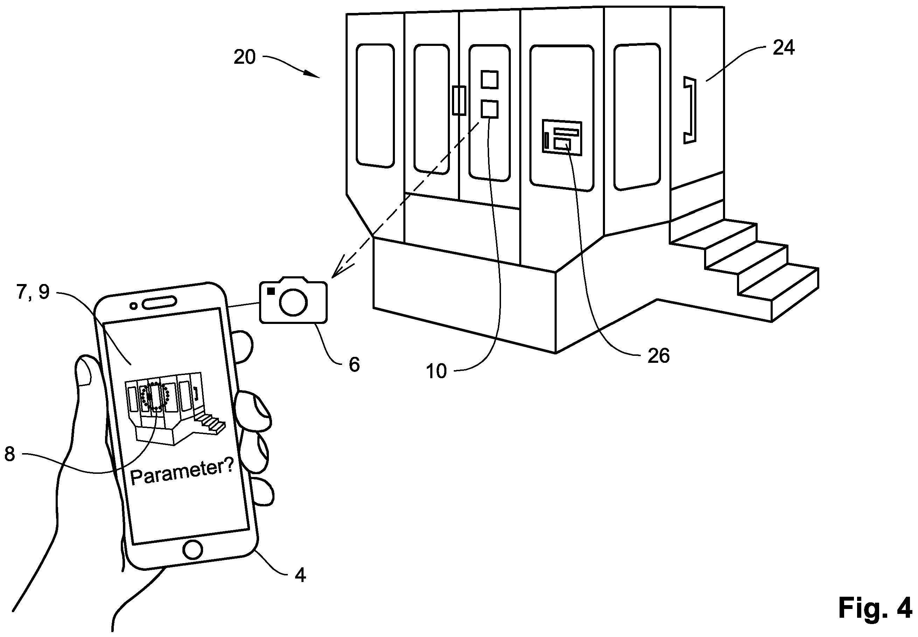

**Fig. 4** zeigt in gleicher Weise die Erfassung weiterer Anlagendaten 10 der in dem Schaltschrank 24 installierten Betriebsmittel mit der Kamera 6 des Assistenzsystems 4.

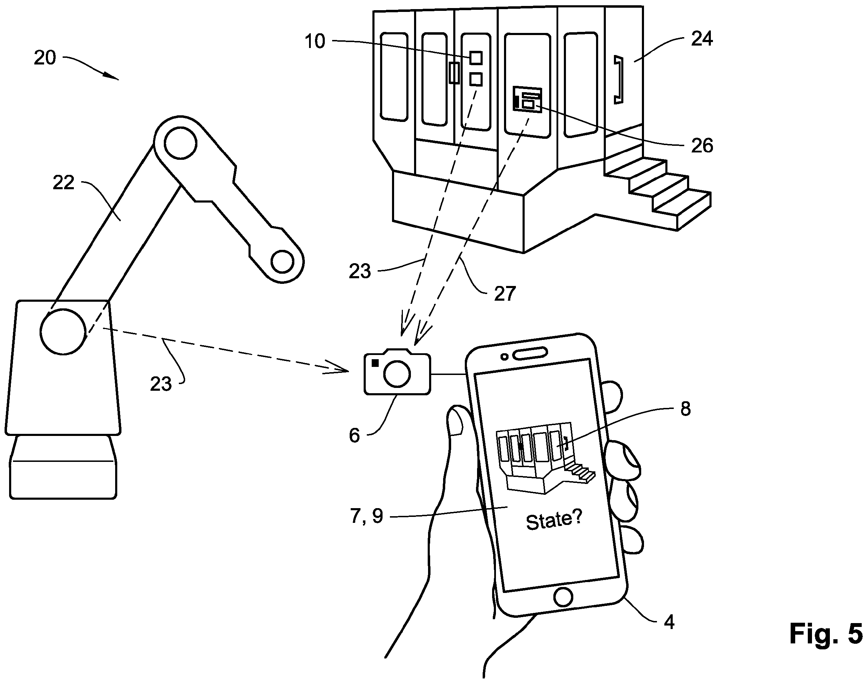

**Fig. 5** zeigt die Computerprogramm-gesteuerte Erfassung von Anlagen-Messdaten 23 sowie die Erfassung von Isolationsüberwachungssystem-Messdaten 27 während des Regelbetriebs der elektrischen Anlage 20.

Mit der Kamera 6 des Assistenzsystems 4 werden gemäß den Handlungsanweisungen 9 sowohl Anlagen-Messdaten 23 des Industrieroboters 22 und der in dem Schaltschrank 24 verbauten Geräte als auch Isolationsüberwachungssystem-Messdaten 27 des Isolationsüberwachungssystems 26 erfasst.

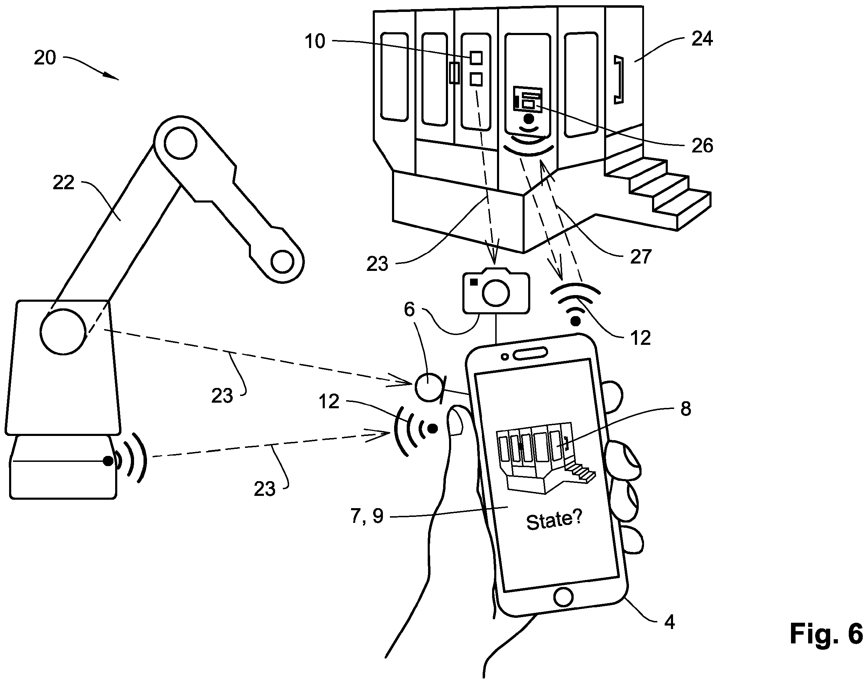

In **Fig. 6** ist die Computerprogramm-gesteuerte Erfassung von Anlagen-Messdaten 23 und von Isolationsüberwachungssystem-Messdaten 27 während des Regelbetriebs in Verbindung mit Funkübertragungsstrecken 12 dargestellt.

Dazu wird zwischen dem Industrieroboter 22 und dem Assistenzsystem 4 sowie zwischen dem Isolationsüberwachungssystem 26 und dem Assistenzsystem 4 jeweils eine Funkübertragungsstrecke 12 eingerichtet. Vorzugsweise beruht diese Funkübertragung 12 auf einem WLAN-Standard oder einem Mobilfunkstandard.

Mittels der Funkübertragungsstrecke 12 zwischen dem Industrieroboter 22 und dem Assistenzsystem 4 werden die in dem Regelbetrieb der Anlage 20 durchfahrenen Betriebszustände des Industrieroboters 22 mit den zugehörigen Anlagen-Messdaten 23 von einem mit einem Funkmodul ausgestatteten Sensor des Industrieroboters 22 an das Assistenzsystem 4 zur Störgrößenermittlung übertragen.

Zusätzlich kann über ein Mikrofon als Sensoreinrichtung 6 des Assistenzsystems 4 eine akustische Aufnahme von Anlagen-Messdaten 23 in dem jeweiligen Betriebszustand erfolgen.

Mittels der Funkübertragungsstrecke 12 zwischen dem Isolationsüberwachungssystem 26 und dem Assistenzsystem 4 werden Isolationsüberwachungssystem-Messdaten 27 an das Assistenzsystem 4 zur Bewertung des Messverhaltens des Isolationsüberwachungssystems 26 übermittelt.

Diese Funkübertragungsstrecke 12 kann auch dazu genutzt werden, um in einem bestimmten Betriebszustand verschiedene, bereits in dem Isolationsüberwachungssystem 26 vorhandene Messprofile Computerprogrammgestützt vor-auszuwählen, zu testen und das Verhalten des Isolationsüberwachungssystems 26 mit dem jeweils vor-ausgewählten Messprofil zu bewerten. Diese Vorgehensweise ist geeignet, um das für diesen Anlagen-Betriebszustand bestmögliche, bereits vorhandene Messprofil zu selektieren.

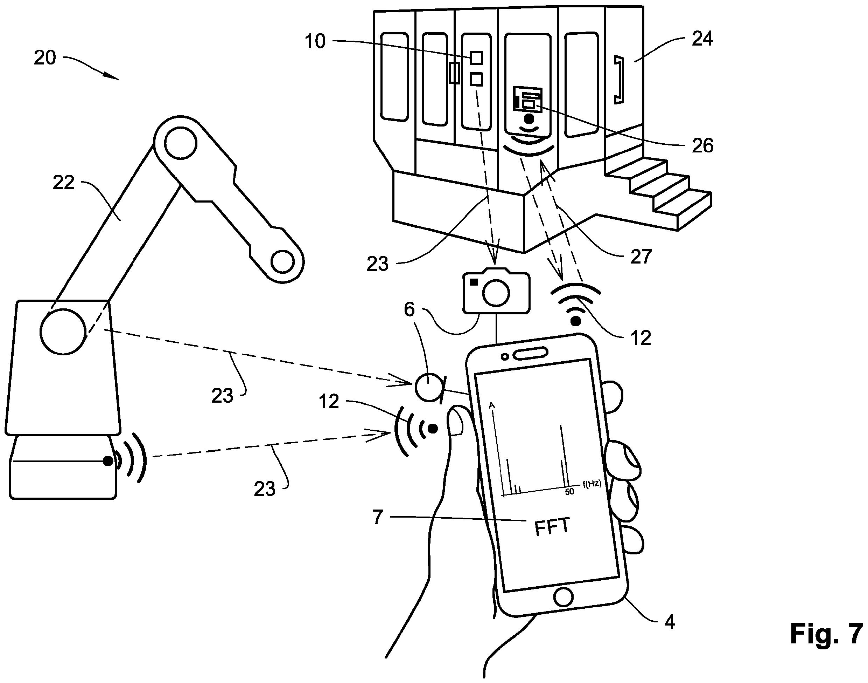

**Fig. 7** zeigt das Ermitteln von Störgrößen aus den erfassten Anlagen-Messdaten 23 mittels digitaler Signalverarbeitungsalgorithmen, welche als Anwendungsprogramm 7 auf dem Assistenzsystem 4 implementiert sind.

Dabei wird ein Mikrofon als Sensoreinrichtung 6 des Assistenzsystems 4 genutzt, um die, überwiegend durch niederfrequente Lastschwankungen erzeugten, für die Messfunktion des Isolationsüberwachungssystems 26 relevanten Störkomponenten, beispielsweise mittels einer Fast-FourierTransformation (FFT als Anwendungsprogramm 7) zu ermitteln.

Über die Funkübertragungsstrecke 12 können alternativ oder zusätzlich die Anlagen-Messdaten 23 an das Assistenzsystem 4 übermittelt werden.

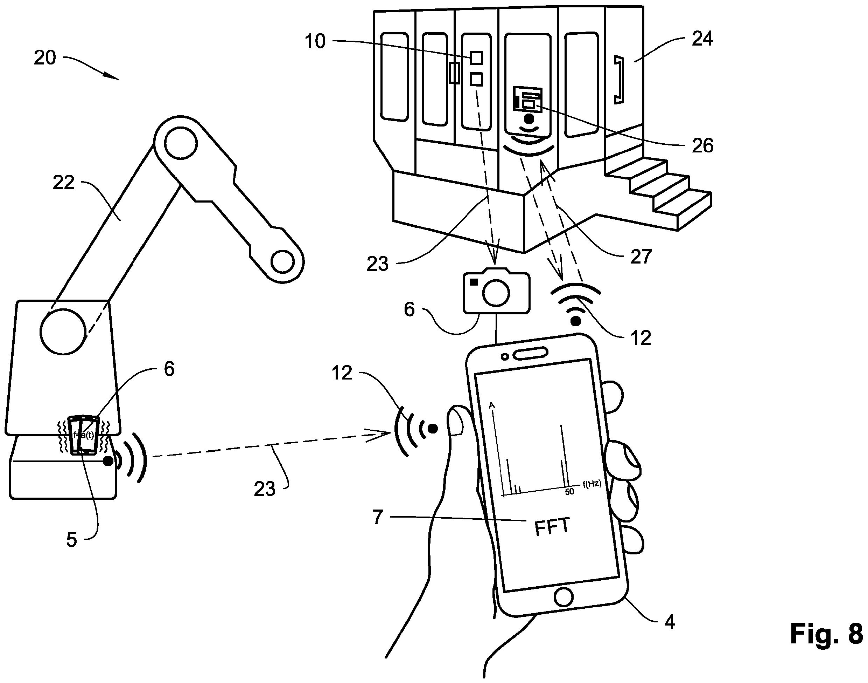

In **Fig.** 8 ist das Ermitteln von Störgrößen mittels eines zweiten mobilen Endgerätes 5 mit einem Beschleunigungssensor als Sensoreinrichtung 6 an dem Industrieroboter 22 dargestellt.

Um einen bestimmten Betriebszustand mit einem spezifischen Bewegungsablauf des Industrieroboters 22 aufzunehmen, ist ein weiteres Assistenzsystem 5 in Ausführung eines zweiten mobilen Endgerätes 5 an dem Industrieroboter 22 angeordnet. Das zweite mobile Endgerät 5 (Smartphone) ist mit einem Beschleunigungssensor als Sensoreinrichtung 6 ausgestattet.

In anderen Anwendungsfällen könnten auch ein Magnetfeldsensor in der Nähe eines Stromversorgungskabels genutzt werden, um kritische Störkomponenten zu ermitteln. In der Anwendungsumgebung von Hochöfen erscheint auch der Gebrauch eines Infrarotsensors der Smartphone-Kamera sinnvoll, um kritische Lastschwankungen zu identifizieren.

Über die von dem zweiten mobilen Endgerät 5 ausgehende Funkübertragungsstrecke 12 werden Beschleunigungsdaten als Anlagen-Messdaten 23 des Industrieroboters 22 an das Assistenzsystem 4 übertragen und dort mittels des Anwendungsprogramms 7, beispielsweise einer FFT, ausgewertet.

## Patentansprüche

1. Verfahren zur automatischen Erstellung von anlagenspezifischen Messprofilen für ein Isolationsüberwachungssytem (26) einer elektrischen Anlage (20), umfassend die Verfahrensschritte:
Computerprogramm-gesteuertes Assistieren mittels eines Assistenzsystems (4) durch geführte Handlungsanweisungen (9) zum Erfassen von technischen und nicht technischen Anlagendaten (10) und teilautomatisiertes und/oder automatisiertes Ausführen der Handlungsanweisungen (9) zum Erfassen der Anlagendaten (10) mittels einer oder mehrerer Sensoreinrichtung(en) (6),
Computerprogramm-gestütztes Vor-Auswählen eines vorhandenen Messprofils aufgrund der erfassten Anlagendaten (10),
Computerprogramm-gesteuertes Assistieren mittels des Assistenzsystems (4) durch geführte Handlungsanweisungen zum Betreiben der elektrischen Anlage (20) in einem Regelbetrieb mit wechselnden Betriebszuständen unter Anwendung des vor-ausgewählten Messprofils mit Erfassen von Anlagen-Messdaten (23) und mit synchronem Aufzeichnen des Messverhaltens des Isolationsüberwachungssystems (26) mittels Speicherung von Isolationsüberwachungssystem-Messdaten (27) während des Regelbetriebs,
Bewerten des Messverhaltens des Isolationsüberwachungssystems (26),
Ermitteln von Störgrößen aus den Anlagen-Messdaten (23), falls sich das Messverhalten als störanfällig erweist, und
Simulieren des Regelbetriebs mit dem vor-ausgewählten Messprofil unter Anwendung der mit den Störgrößen behafteten Anlagen-Messdaten (23) und anschließendem
Optimieren des vor-ausgewählten Messprofils durch Anpassen von Messprofil-Parametern im Hinblick auf eine störresistente Isolationsüberwachung.

2. Verfahren nach Anspruch 1,
**dadurch gekennzeichnet,**
**dass** das Assistenzsystem (4) ein Endgerät des Anlagenbetreibers in Form eines Smartphones, eines Tablet-PCs, eines Notebooks, einer Virtual Reality Brille oder Augmented Reality Brille ist und das Computerprogramm-gesteuerte Assistieren mittels eines auf dem Endgerät ausführbaren Anwendungsprogramms (7) erfolgt.

3. Verfahren nach Anspruch 1 oder 2,
**dadurch gekennzeichnet,**
**dass** das Computerprogramm-gesteuerte Assistieren durch Virtual Reality Verfahren und/oder Augmented Reality Verfahren (8) unterstützt wird.

4. Verfahren nach einem der Ansprüche 1 bis 3,
**dadurch gekennzeichnet,**
**dass** das Erfassen der Anlagendaten sowie der Anlagen-Messdaten (23) mittels in dem Assistenzsystem verbauter Sensoreinrichtungen (6) erfolgt.

5. Verfahren nach einem der Ansprüche 1 bis 4,
**dadurch gekennzeichnet,**
**dass** bei dem Optimieren des vor-ausgewählten Messprofils durch Anpassen von Messprofil-Parametern Verfahren der Künstlichen Intelligenz angewendet werden.

6. Verfahren nach einem der Ansprüche 1 bis 5,
**dadurch gekennzeichnet,**
**dass** eine Übertragung der Anlagen-Messdaten (23) und der Isolationsüberwachungssystem-Messdaten (27) mittels einer Funkübertragungsstrecke (12) erfolgt.

## Claims

1. A method for automatically creating installation-specific measuring profiles for an insulation monitoring system (26) of an electric installation (20), the method comprising the following steps:
assisting in a computer-controlled manner by means of an assist system (4) via guided instructions (9) for detecting technical and non-technical installation data (10), and
partially automatically and/or automatically executing the instructions (9) for acquiring the installation data (10) by means of one more sensor devices (6),
pre-selecting in a computer-aided manner an available measuring profile based on the acquired installation data (10),
assisting in a computer-aided manner by means of the assist system (4) via guided instructions for operating the electric installation (20) during regular operation with changing operating states using the preselected measuring profiles with acquiring installation measured data (23), and with
synchronously recording the measuring behavior of the insulation monitoring system (26) by means of storing insulation-monitoring system measured data (27) during regular operation,
evaluating the measuring behavior of the insulation monitoring system (26),
detecting disturbance variables from installation measured data (23) if the measuring behavior proves to be prone to disturbances, and
simulating regular operation with the preselected measuring profile using the installation measured data (23) afflicted with the disturbance variables, and subsequently
optimizing the preselected measuring profile by adapting measuring-profile parameters with regard to a disturbance-resistant insulation monitoring.

2. The method according to claim 1,
**characterized in that**
the assist system (4) is an end device of the installation operator in the form of a smartphone, a tablet PC, a notebook, virtual reality glasses or augmented reality glasses, and the computer-controlled assisting takes place by means of an application (7) executable on the end device.

3. The method according to claim 1 or 2,
**characterized in that**
the computer-controlled assisting is supported by virtual reality methods and/or augmented reality methods (8).

4. The method according to any one of the claims 1 to 3,
**characterized in that**
the installation data and the installation measured data (23) are acquired by means of sensor devices (6) installed in the assist system.

5. The method according to any one of the claims 1 to 4,
**characterized in that**
when the preselected measuring profile is optimized by adapting measuring-profile parameters, methods of artificial intelligence are employed.

6. The method according to any one of the claims 1 to 5,
**characterized in that**
the installation measured data (23) and the installation-monitoring-device measured data (27) are transmitted by means of a radio transmission path (12).

## Revendications

1. Procédé de création automatique de profils de mesure spécifiques à l'installation pour un système (26) de surveillance de l'isolement d'une installation électrique (20), le procédé comprenant les étapes suivantes :
l'assistance commandée par ordinateur au moyen d'un système d'assistance (4) par des instructions guidées (9) pour la saisie de données d'installation (10) techniques et non techniques, et
l'exécution partiellement automatique et/ou automatique des instructions (9) pour la saisie des données d'installation (10) au moyen d'un ou de plusieurs dispositifs de capteur (6),
la présélection commandée par ordinateur d'un profil de mesure disponible sur la base des données d'installation (10) acquises,
l'assistance commandée par ordinateur au moyen du système d'assistance (4) par des instructions guidées pour le fonctionnement de l'installation électrique (20) pendant un fonctionnement régulier avec des états de fonctionnement changeants en utilisant les profils de mesure présélectionnés avec la saisie des données (23) de mesure de l'installation, et
la saisie synchrone du comportement de mesure du système (26) de surveillance de l'isolement au moyen de l'enregistrement des données de mesure (27) du système de surveillance de l'isolement pendant le fonctionnement régulier,
l'évaluation du comportement de mesure du système (26) de surveillance de l'isolement,
la détection des variables de perturbation à partir des données (23) de mesure de l'installation si le comportement de mesure s'avère être sujet à des perturbations, et
la simulation du fonctionnement régulier avec le profil de mesure présélectionné à l'aide des données (23) de mesure de l'installation affectées par les variables de perturbation, et puis l'optimisation du profil de mesure présélectionné en adaptant des paramètres du profil de mesure en fonction d'une surveillance d'isolement résistante aux perturbations.

2. Procédé selon la revendication 1,
**caractérisée en ce que**
le système d'assistance (4) est un dispositif terminal de l'opérateur d'installation sous la forme d'un smartphone, d'une tablette PC, d'un ordinateur portable, de lunettes de réalité virtuelle ou de lunettes de réalité augmentée, et **en ce que** l'assistance commandée par ordinateur a lieu au moyen d'une application (7) exécutable sur le dispositif terminal.

3. Procédé selon la revendication 1 ou la revendication 2,
**caractérisée en ce que**
l'assistance commandée par ordinateur est soutenue par des procédés de réalité virtuelle et/ou des procédés (8) de réalité augmentée.

4. Procédé selon l'une quelconques des revendications 1 à 3,
**caractérisée en ce que**
les données d'installation et les données (23) de mesure d'installation sont saisies au moyen de dispositifs de capteur (6) installés dans le système d'assistance.

5. Procédé selon l'une quelconque des revendications 1 à 4,
**caractérisée en ce que**
lorsque le profil de mesure présélectionné est optimisé en adaptant les paramètres du profil de mesure, des procédés d'intelligence artificielle sont utilisées.

6. Procédé selon l'une quelconque des revendications 1 à 5,
**caractérisé en ce que**
les données (23) de mesure de l'installation et les données de mesure du dispositif (27) de surveillance d'isolement sont transmises au moyen d'une voie de transmission radio (12).
